# EUROPEAN PATENT APPLICATION

(11) **EP 1 367 638 A1**
(43) Date of publication of application: **03.12.2003**
(21) Application number: 02701589.0
(22) Date of filing: 27.02.2002
(51) Int. Cl.: H01L 21/3065, H01L 21/768

(54) **METHOD FOR ETCHING ORGANIC INSULATING FILM AND DUAL DAMASENE PROCESS**

(30) Priority: 08.03.2001 JP 2001065459
(71) Applicant: Tokyo Electron Limited, Tokyo 107-8481 (JP)
(72) Inventor: IGARASHI, Yoshiki, Tokyo Electron At Limited, Nirasaki-shi, Yamanashi 407-8511 (JP); SUEMASA, Tomoki, Tokyo Electron Massachusetts, Llc, Santa Clara, CA 95054 (US); INAZAWA Koichiro, Tokyo Electron Massachusetts Llc, Beverly, MA 01915 (US)
(74) Representative: HOFFMANN - EITLE
(86) International application number: JP0201787
(87) International publication number: WO02073674

(57) **Abstract**

The flow ratio of Ar is set to 80% or higher when an SiOC-based low dielectric constant film is etched using a C₄F₈/Ar/N₂-based mixed gas. This can increase the selection ratio of the sire-based low dielectric constant film to a silicon nitride film and can make a micro-trench produced during etching smaller.

## Description

### Technical Field

The present invention relates to a method for etching an organic insulating film and a dual damascene process, more particularly, to what is suitable for use in the dual damascene process using a low dielectric constant insulating film as an interlayer insulating film.

### Background Art

A conventional method for etching an SiOC-based low dielectric constant film has used, for example, a C₄F₈/Ar/N₂-based mixed gas or a C₄F₈/CO/Ar/N₂-based mixed gas in which the Ar flow ratio is 60% or lower. CO has been used for the purpose of controlling the deposition state of carbon-based polymer which influences the etching shape or the selectivity to a foundation film.

However, in the conventional method for etching the SiOC-based low dielectric constant film (containing Si, O, C, and H as its components), the selection ratio of the SiOC-based low dielectric constant film to a silicon nitride film (the etching rate of the SiOC-based low dielectric constant film/the etching rate of the silicon nitride film) is low, and an obtainable value thereof has been only about 2 to 3. Therefore, when via holes are formed in the SiOC-based low dielectric constant film, with the silicon nitride film serving as an etch stop layer, there has arisen a problem of difficulty in etching stop of the SiOC-based low dielectric constant film.

Moreover, in the conventional method for etching the SiOC-based low dielectric constant film, micro-trenches (irregularities formed in the bottoms of holes) are large, the level difference thereof being 50 nm or more. Consequently, when trenches for buried wiring are formed in the SiOC-based low dielectric constant film, there has arisen a problem of unevenness in the buried state of wiring materials.

### Disclosure of the Invention

It is an object of the present invention to provide a method for etching an organic insulating film and a dual damascene process that make it possible to enhance the selection ratio of the organic insulating film to a silicon nitride film and to make micro-trenches smaller.

In order to solve the problems stated above, an aspect of the present invention is characterized in that an etching gas is a mixed gas containing a fluorocarbon-based gas, an N₂ gas, and an inert gas whose flow ratio to a total flow rate of the etching gas is 80% or higher. This increases the sputtering force by the inert gas, so that it becomes possible to etch the organic insulating film while removing carbon-based polymer depositing on bottom faces of holes, thereby making it possible to make the micro-trenches smaller. Further, when the flow ratio of the inert gas is set to 80% or higher, it is possible to prevent excessive supply of fluorine radicals that are etching species of a nitride film to the bottom faces of the holes, thereby enhancing the selection ratio of the organic insulating film to the nitride silicon film.

Another aspect of the present invention is characterized in that the organic insulating film is an SiOC-based low dielectric constant film.

This makes it possible to form by CVD an interlayer insulating film excellent in mechanical strength and thermal stability and having relative dielectric constant roughly in a range from 2.4 to 2.7, and to prevent wiring delay while maintaining compatibility with a conventional thin film forming process, so that the number of steps of a dual damascene process can be greatly reduced.

Still another aspect of the present invention is characterized in that a selection ratio of the organic insulating film to a silicon nitride film (etching rate of the organic insulating film/etching rate of the silicon nitride film) is about 10 or higher.

This prevents the silicon nitride film from being shaved in overetching even when the silicon nitride film is used as an etch stop layer in etching the organic insulating film, so that via holes can be formed with high precision.

Yet another aspect of the present invention is characterized in that a micro-trench value by the etching gas is 40 nm or less.

Consequently, the shape of the wiring trench bottoms can be planarized even when trenches for buried wiring (wiring trenches) are formed in the organic insulating film, so that wiring materials can be buried uniformly.

Yet another aspect of the present invention is characterized in that it includes: etching an organic insulating film with a resist film serving as a mask layer, by using an etching gas containing a hydrofluorocarbon-based gas, an N₂ gas, and an inert gas whose flow ratio to a total flow rate of the etching gas is 80% or higher.

Yet another aspect of the present invention is characterized in that it includes: forming a via hole in an organic insulating film with a nitride film serving as an etch stop layer, by using an etching gas containing a fluorocarbon-based gas, an N₂ gas, and an inert gas whose flow ratio to a total flow rate of the etching gas is 80% or higher; etching the organic insulating film halfway to a bottom by using the etching gas, to thereby form a trench in the organic insulating film; and burying a conductive material in the via hole and the trench.

This allows the enhancement in the selection ratio to the silicon nitride film when the organic insulating film is etched, so that proper etch stop is realized even when the via holes are formed in the organic insulating film with the nitride film serving as the etch stop layer. This also makes it possible to make micro-trenches smaller, so that the shape of the trench bottoms can be planarized even when the etching of the organic insulating film is stopped halfway, which makes it possible to bury the conductive material uniformly.

Yet another aspect of the present invention is characterized in that the inert gas is an Ar gas, the fluorocarbon-based gas is a C₄F₈ gas or a C₄F₆ gas, and the hydrofluorocarbon-based gas is a CHF₃ gas.

### Brief Description of Drawings

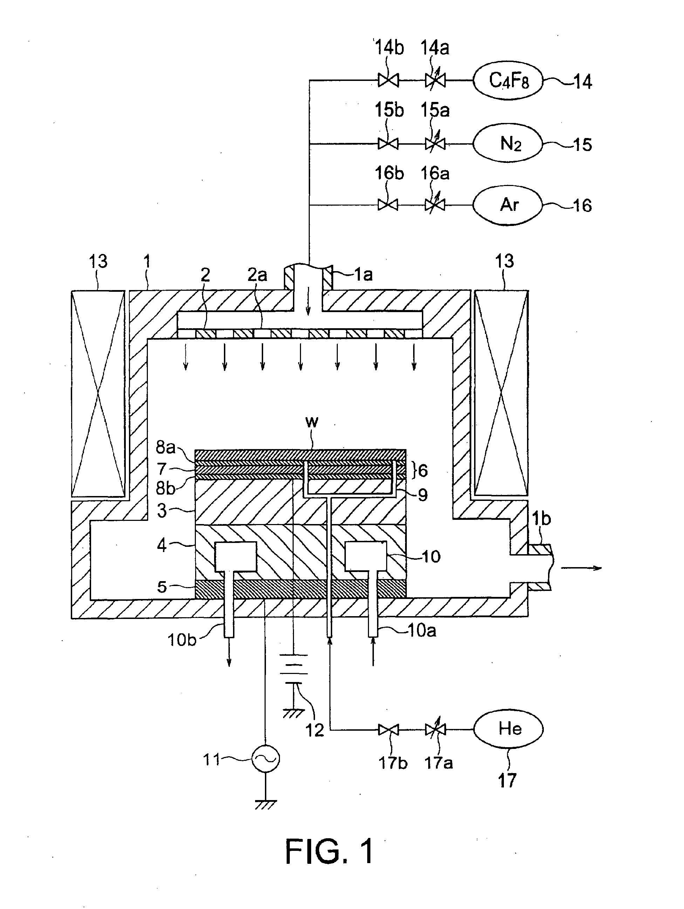

FIG. 1 is a cross sectional view showing the schematic configuration of an etching apparatus according to an embodiment of the present invention.

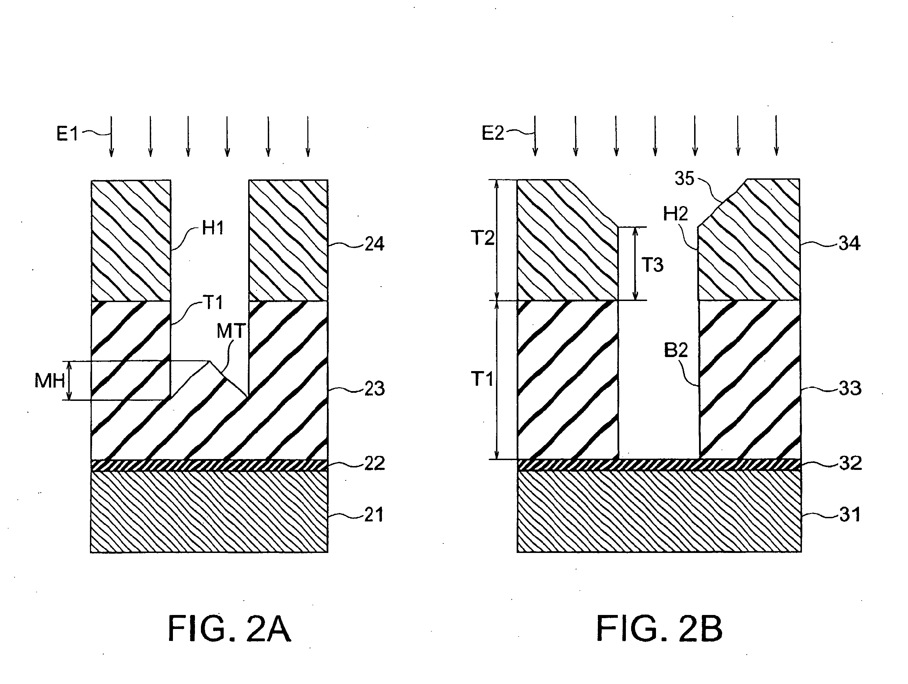

FIG. 2A and FIG. 2B are views for explaining examples of the present invention, FIG. 2A being a cross sectional view showing the state of a trench according to an example and FIG. 2B being a cross sectional view showing the state of a via hole according to an example.

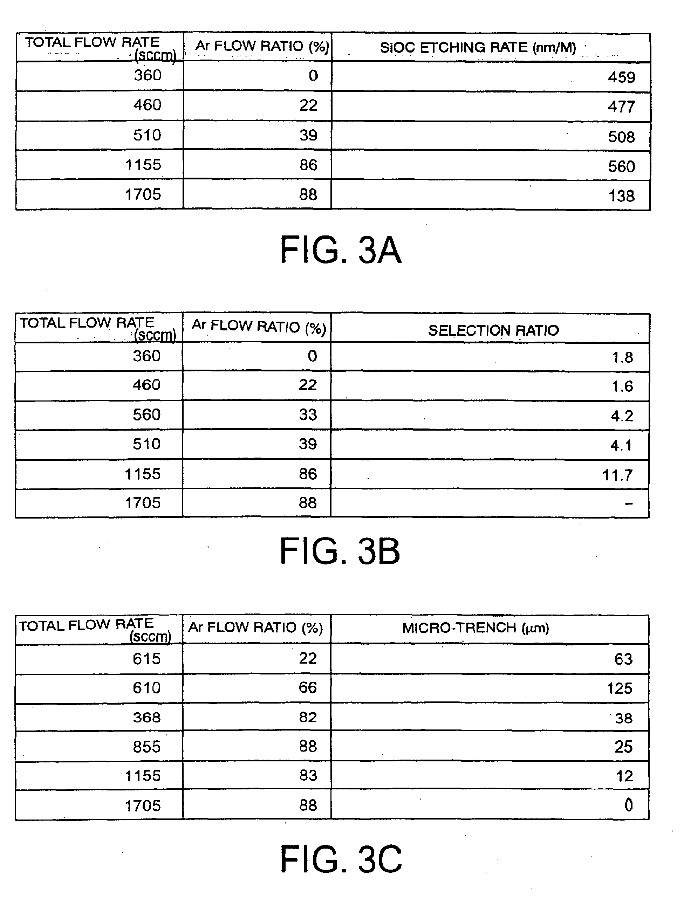

FIG. 3A, FIG. 3B, and FIG. 3C are charts for explaining an example of the present invention, FIG. 3A being a chart numerically representing the correlation between the Ar flow ratio and the etching rate of an Sioc film according to the example, FIG. 3B being a chart numerically representing the correlation between the Ar flow ratio and the selection ratio of the SiOC film to a silicon nitride film according to the example, and FIG. 3C being a chart numerically representing the correlation between the Ar flow ratio and the micro-trench value according to the example.

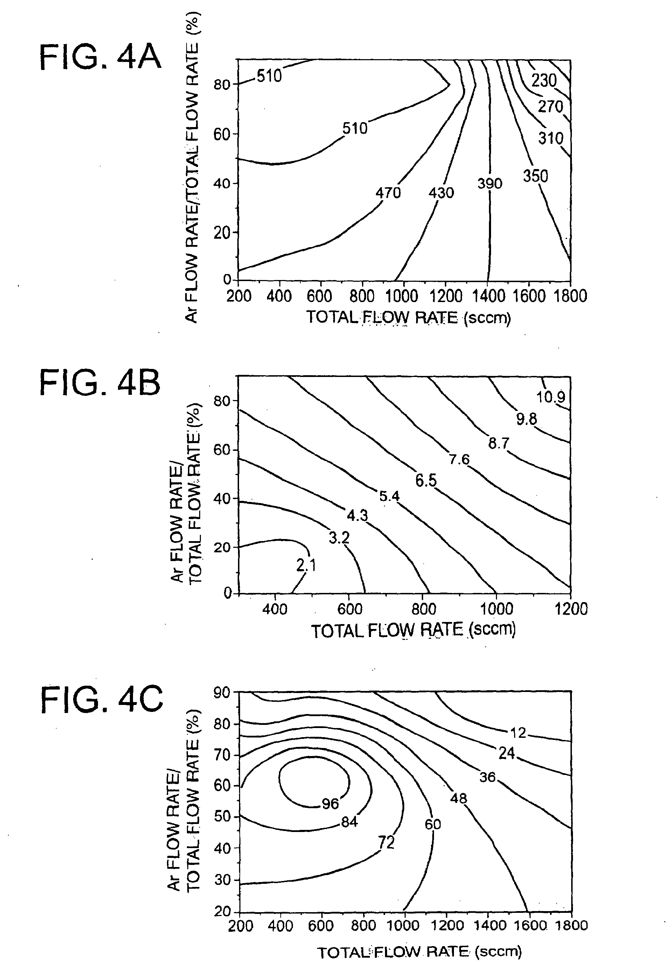

FIG. 4A, FIG. 4B, and FIG. 4C are views for explaining the example of the present invention, FIG. 4A being a contour map representing the correlation between the Ar flow ratio and the etching rate of the SiOC film in an etching method according to the example, FIG. 4B being a contour map representing the correlation between the Ar flow ratio and the selection ratio of the SiOC film to the silicon nitride film in the etching method according to the example, and FIG. 4C being a contour map representing the correlation between the Ar flow ratio and the micro-trench value in the etching method according to the example.

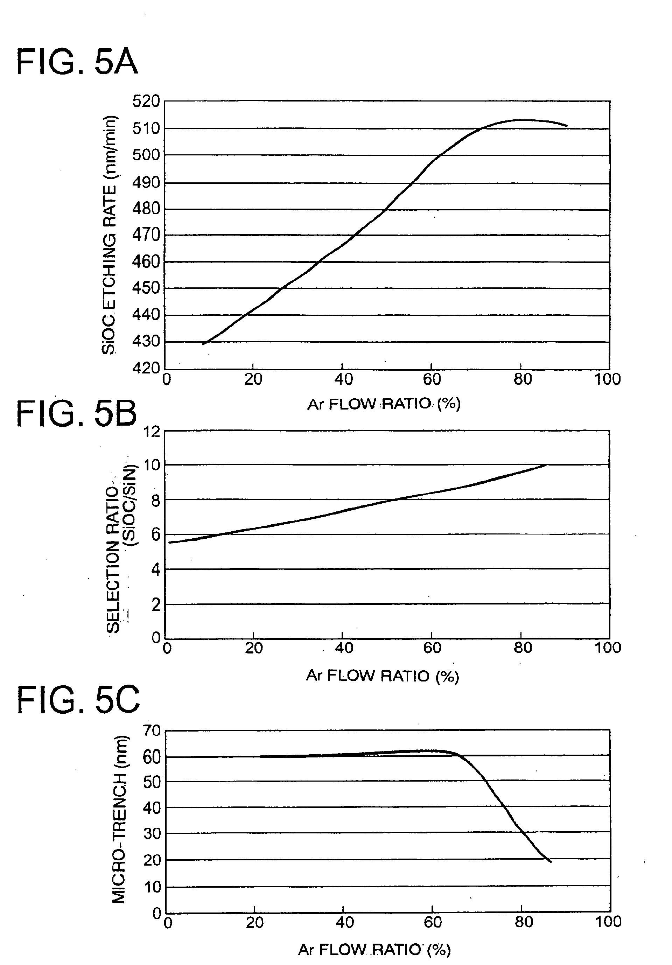

FIG. 5A, FIG. 5B, and FIG. 5C are charts for explaining the example of the present invention, FIG. 5A being a chart representing the correlation between the Ar flow ratio and the etching rate of the SiOC film at the total flow rate of 1000 sccm according to the example, FIG. 5B being a chart representing the correlation between the Ar flow ratio and the selection ratio of the SiOC film to the silicon nitride film at the total flow rate of 1000 sccm according to the example, and FIG. 5C being a chart representing the correlation between the Ar flow ratio and the micro-trench value at the total flow rate of 1000 sccm according to the example.

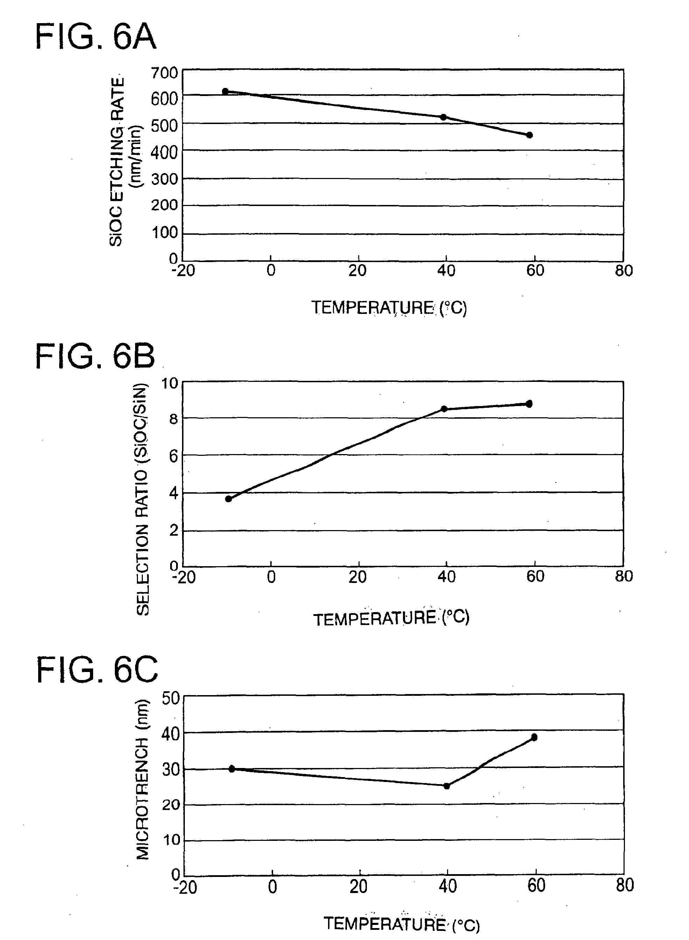

FIG. 6A, FIG. 6B, and FIG. 6C are charts for explaining an example of the present invention, FIG. 6A being a chart representing temperature dependency of the etching rate of an SiOC film according to the example, FIG. 6B being a chart representing temperature dependency of the selection ratio of the SiOC film to a silicon nitride film in an etching method according to the example, and FIG. 6C being a chart representing temperature dependency of the micro-trench value according to the example.

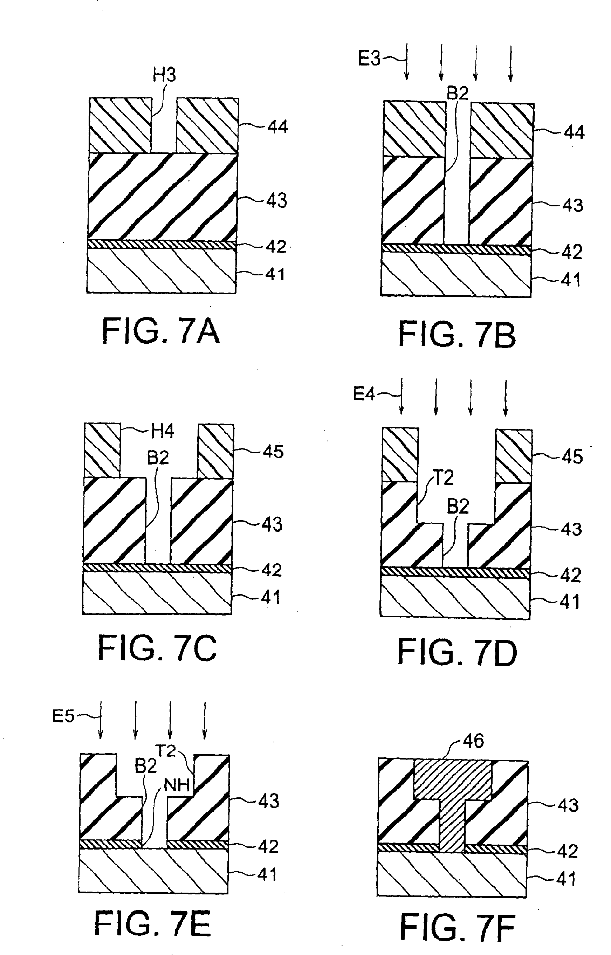

FIG. 7A, FIG. 7B, FIG. 7C, FIG. 7D, FIG. 7E, and FIG. 7F are cross sectional views showing a dual damascene process according to an embodiment of the present invention.

### Best Mode for Implementing the Invention

Hereinafter, an etching method according to an embodiment of the present invention will be explained with reference to the drawings.

FIG. 1 is a cross sectional view showing the schematic configuration of an etching apparatus according to an embodiment of the present invention. In this embodiment, the explanation will be given on the case when a C₄F₈/Ar/N₂-based mixed gas is used as an etching gas.

In FIG. 1, a top electrode 2 and a susceptor 3 are provided in a process chamber 1, this susceptor 3 also serving as a bottom electrode. The top electrode 2 has gas blowout ports 2a through which an etching gas is introduced into the process chamber 1, the susceptor 3 is supported on a susceptor supporting table 4, and the susceptor supporting table 4 is held in the process chamber 1 via an insulating plate 5. A radio-frequency power source 11 is connected to the susceptor 3 to plasmatize the etching gas introduced into the process chamber 1.

A refrigerant chamber 10 is provided in the susceptor supporting table 4, and a refrigerant such as liquid nitrogen circulates inside the refrigerant chamber 10 via a refrigerant supply pipe 10a and a refrigerant discharge pipe 10b. Then, cold heat generated therefrom is transferred to a wafer W via the susceptor supporting table 4 and the susceptor 3, so that the wafer W can be cooled.

An electrostatic chuck (ESC) 6 is provided on the susceptor 3, and the electrostatic chuck 6 is so structured that a conductor layer 7 is sandwiched by polyimide films 8a, 8b. A DC high-voltage power source 12 is connected to the conductor layer 7 and the application of a DC high voltage to the conductor layer 7 causes a Coulomb force to act on the wafer w, so that the wafer W can be fixed onto the susceptor 3.

A gas passage 9 through which a He gas is introduced is formed in the susceptor 3 and the electrostatic chuck 6, and the wafer W placed on the susceptor 3 can be cooled by the ejection of the He gas to a back face of the wafer W via this gas passage 9. The gas passage 9 is connected to a He gas supply source 17 via a flow rate adjusting valve 17a and an opening/closing valve 17b, so that the pressure of the He gas to the back face of the wafer W can be controlled.

The process chamber 1 has a gas supply pipe 1a and an exhaust pipe 1b and the gas supply pipe 1a is connected to a C₄F₈ gas supply source 14, an N₂ gas supply source 15, and an Ar gas supply source 16 via flow rate adjusting valves 14a to 16a and opening/closing valves 14b to 16b. The exhaust pipe 1b is connected to a vacuum pump, and when the inside of the process chamber 1 is exhausted by this vacuum pump, the pressure in the process chamber 1 can be adjusted. A horizontal magnetic field forming magnet 13 is provided to surround the process chamber 1, and the formation of a magnetic field in the process chamber 1 increases the density of plasma to enable efficient etching.

When the wafer W is processed by this etching apparatus, the wafer W on which an organic insulating film has been formed by using a silicon nitride film as an etch stop layer is placed on the susceptor 3 and is fixed thereto by the electrostatic chuck 6.

Next, the process chamber 1 is exhausted to adjust the pressure inside the process chamber 1, and at the same time, the opening/closing valves 14b to 16b are opened to introduce a C₄F₈ gas, an N₂ gas, and an Ar gas into the process chamber 1. Here, the flow ratios of the C₄F₈ gas, the N₂ gas, and the Ar gas can be adjusted by the flow rate adjusting valves 14a to 16a.

Next, an RF power from the radio-frequency power source 11 is applied to the susceptor 3 to plasmatize the etching gas, thereby etching the organic insulating film. At this time, the opening/closing valve 17b is opened to introduce the He gas into the gas passage 9 and the He gas is ejected from the gas passage 9, so that the wafer W can be cooled. Further, when the flow rate adjusting valve 17a is used to adjust the pressure of the He gas, the cooling temperature of the wafer W can be controlled.

Here, when the flow ratio of Ar in the C₄F₈/Ar/N₂-based mixed gas is set to 80% or higher, the selection ratio to the silicon nitride film can be increased and micro-trenches can be made smaller. Incidentally, such settings are preferable that the RF power is 500 W to 2000 W, the pressure is 1.33 Pa to 133 Pa, the He pressure to the back face of the wafer W is 665 Pa to 1995 Pa at the center and 2660 Pa to 6650 Pa at the edge, and the bottom ESC temperature is -20°c to 60°c.

FIG. 2A is a cross sectional view showing the state of a trench according to an example of the present invention. In FIG. 2A, an SiOC film 23 is formed on a substrate 21 via a silicon nitride film 22. Etching E1 is conducted for the SiOC film 23 halfway to the bottom thereof, using a photoresist film 24 having an opening portion H1 formed therein as a mask, thereby forming a trench T1. Here, when the etching E1 is conducted for the SiOC film 23 through the use of the C₄F₈/Ar/N₂-based mixed gas, a larger volume of carbon-based polymer generated at this time is deposited near the center of the bottom face of the trench T1. Consequently, in the trench T1, the progress of the etching is inhibited near the center of the bottom face of the trench T1, so that an etching amount becomes larger from the center toward the edge. consequently, a micro-trench MT that is a dimple at the edge of the bottom face of the trench T1 is formed.

Here, when the flow ratio of Ar in the C₄F₈Ar/N₂-based mixed gas is set to 80% or higher, the sputtering force by the Ar gas is increased to allow the removal of the carbon-based polymer deposited on the bottom face of the trench T1. Accordingly, uniform etching progress is realized over the entire bottom face of the trench T1 to make the micro-trench MT smaller, so that the value of the micro-trench MH can be controlled to be 40 nm or less.

FIG. 2B is a cross sectional view showing the state of a via hole according to an example of the present invention. In FIG. 2B, an SiOC film 33 is formed on a substrate 31 via a silicon nitride film 32. When etching E2 is conducted for the SiOC film 33, using a photoresist film 34 having an opening portion H2 formed therein as a mask, a via hole B2 is formed. Here, when the etching E2 is conducted using a C₄F₈/Ar/N₂-based mixed gas, carbon-based polymer inhibiting the etching progress is generated due to the dissociation of a C₄F₈ gas and the reaction with the SiOC film 33, and fluorine radicals promoting the etching of the silicon nitride film 32 is also generated. The carbon-based polymer, which generally has a large molecular weight, does not easily infiltrate deep into the via hole B2 and thus tends to be easily deposited on a sidewall near an entrance of the via hole B2. Therefore, on the silicon nitride film 32 that is positioned in the bottom portion of the via hole B2, the carbon-based polymer does not contribute much to the inhibition of the etching, and moreover, the fluorine radicals become excessive, so that the etching of the silicon nitride film 32 is promoted.

Here, when the flow ratio of Ar in the C₄F₈/Ar/N₂-based mixed gas is set to 80% or higher, the sputtering force by the Ar gas is increased, so that the carbon-based polymer deposited on the sidewall of the via hole B2 can be removed. This allows the carbon-based polymer to easily infiltrate deep into the via hole B2 to increase the carbon-based polymer deposited on the silicon nitride film 32, and at the same time, enables the reduction in the fluorine radicals on the silicon nitride film 32, thereby inhibiting the etching progress of the silicon nitride film 32. As a result, the selection ratio of the SiOC film 33 to the silicon nitride film 32 can be increased, and this selection ratio can be increased to 10 or higher.

FIG. 3A is a numerical example representing the correlation between the Ar flow ratio and the etching rate of an SiOC film according to an example of the present invention, FIG. 4A is a contour map drawn based on the numerical example in FIG. 3A, and FIG. 5A is a chart in which data at the total flow rate of 1000 sccm is graphed based on the contour map in FIG. 4A. Incidentally, the RF power was set to 1500 W, the pressure was set to 13.3 Pa, the He pressure to the back face of a wafer W was set to 931 Pa at the center and 5320 Pa at the edge, and the bottom ESC temperature was set to 40°C. The interval between electrodes was 37 mm, the diameter of a susceptor was 260 mm, and the RF frequency was 13.56 MHz.

In FIG. 5A, the etching rate of the SiOC film increases in accordance with the increase in the Ar flow ratio, and becomes substantially constant when the Ar flow ratio is about 80% or higher. The etching rate of the SiOC film tends to decrease in accordance with the increase in the Ar flow ratio after the total flow rate exceeds 1200 sccm, as shown in FIG. 3A and FIG. 4A. This is because the C₄F₈ gas flow rate adjustable range is about 5 sccm to about 15 sccm and the N₂ gas flow rate adjustable range is about 100 sccm to about 300 sccm due to the restriction in terms of the apparatus, and the excessive increase in the total flow rate causes the excessive decrease in the ratio of the C₄F₈ gas that is to be etching species, thereby inhibiting the etching progress.

FIG. 3B is a numerical example representing the correlation between the Ar flow ratio and the selection ratio of the SiOC film to a silicon nitride film according to the example of the present invention, FIG. 4B is a contour map drawn based on the numerical example in FIG. 3B, and FIG. 5B is a chart in which data at the total flow rate of 1000 sccm is graphed based on the contour map in FIG. 4B.

In FIG. 5B, the selection ratio of the SiOC film to the silicon nitride film increases in accordance with the increase in the Ar flow ratio, and the selection ratio reaches about 10 when the Ar flow ratio is 80% or higher. The possible reason for this is that the increase in the Ar flow ratio increases the sputtering force by an Ar gas, so that a carbon-based gas easily infiltrates deep into a via hole and a fluorine gas promoting the etching of the silicon nitride film is forced out of the bottom portion of the via hole.

FIG. 3C is a numerical example representing the correlation between the Ar flow ratio and the micro-trench value according to the example of the present invention, FIG. 4C is a contour map drawn based on the numerical example in FIG. 3C, and FIG. 5C is a chart in which data at the total flow rate of 1000 sccm is graphed based on the contour map in FIG. 4C.

In FIG. 5C, when the Ar flow ratio is 60% or higher, the micro-trench value decreases in accordance with the increase in the Ar flow ratio. The possible reason for this is that the increase in the Ar flow ratio increases the sputtering force by the Ar gas, so that the thickness of the carbon-based polymer deposited on the bottom face of the trench can be made uniform.

As a result, by the use of, for example, the C₄F₈/N₂/Ar-based mixed gas at the flow ratio of 5/150/1000 sccm (the total flow rate: 1155 sccm, the Ar flow ratio: 87%), it was possible to obtain the etching rate of 560 nm/min for the SiOC film, the selection ratio of 11.7 for the SiOC film to the silicon nitride film, and the micro-trench value of 12 nm.

FIG. 6A is a chart showing bottom ESC temperature dependency of the etching rate of an SiOC film according to an example of the present invention. In this example, a C₄F₈/N₂/Ar-based mixed gas was used at the flow ratio of 5/100/750 sccm. The RF power was set to 1500 W, the pressure was set to 9.31 Pa, and the He pressure to the back face of the wafer W was set to 931 Pa at the center and 5320 Pa at the edge.

As shown in FIG. 6A, the etching rate of the SiOC film gradually decreases in accordance with the increase in the bottom ESC temperature.

FIG. 6B is a chart showing temperature dependency of the selection ratio of the SiOC film to a silicon nitride film in an etching method according to the example of the present invention. As shown in FIG. 6B, the selection ratio of the SiOC film to the silicon nitride film increases in accordance with the increase in the bottom ESC temperature before the bottom ESC temperature reaches about 40°C, and is kept substantially constant thereafter. FIG. 6C is a chart showing temperature dependency of the micro-trench value according to the example of the present invention. As shown in FIG. 6C, the micro-trench value gradually decreases in accordance with the increase in the bottom ESC temperature before the bottom ESC temperature reaches about 40°C, and drastically increases thereafter. These results show that the bottom ESC temperature of about 40°C is appropriate for increasing the selection ratio of the SiOC film to the silicon nitride film while controlling the micro-trench at the lowest value possible. The practical range is from 20°C to 50°C or lower.

In the above-described embodiment, the explanation is given on the case when the C₄F₈ gas is used as the fluorocarbon-based gas, but any fluorocarbon-based gas may be used, and for example, a CF₄ gas, a C₂F₄ gas, a C₂F₆ gas, a C₃F₆ gas, a C₃F₈ gas, a C₄F₆ gas, a C₄F₈ gas (linear and cyclic), a C₅F₈ gas (linear and cyclic), or a C₅F₁₀ gas may be used. For example, as an example of using these gases, a C₄F₆/N₂/Ar-based mixed gas was used at the flow ratio of 5/200/1000 sccm (the total flow rate: 1205 sccm, the Ar flow ratio: 83%). The RF power was set to 1500 W, the pressure was set to 13.3 Pa, the He pressure to the back face of the wafer W was set to 931 Pa at the center and 5320 at the edge, and the bottom temperature was set to 40°C. As a result, the etching rate of 408 nm/min for the SiOC film and the selection ratio of 20 for the SiOC film 33 to the silicon nitride film 32 were achieved.

The case when the Ar gas was used as the inert gas was explained, but similar behavior can be expected with any inert gas, for example, a helium gas, a neon gas, and a xenon gas, owing to the behavior of Ar in the present invention.

The SiOC-based low dielectric constant film was explained as the organic insulating film, but either an organic low-k film (containing C, O, and H as components thereof and not containing Si) or a hybrid low-k film (containing Si in addition to C, O, and H) may be used, and for example, usable are, in addition to a PAE (poly aryleneether)-based film such as "SiLK (manufactured by the Dow Chemical Co., USA)", an HSQ (hydrogen silsesquioxane)-based film, an MSQ (methyl silsesquioxane)-based film, a PCB-based film, a CF-based film, an SiOC-based film such as "CORAL (manufactured by Novellus Systems, Inc, USA)", "Black Diamond (manufactured by Applied Materials, Inc, USA)", and "Aurora 2.7 (ASM Japan)", an SiOF-based film, or a porous film of these films.

The organic insulating film may have a multilayer structure, or may be so structured that an inorganic material film such as SiO₂, SiON, or SiN is interposed between layers of an organic insulating film having a multilayer structure.

In the above-described embodiment, the etching method using a magnetron RIE apparatus was explained, but the present invention may be also applied to an ECR (electronic cyclotron resonance) plasma etching apparatus, a HEP (helicon wave excited plasma) etching apparatus, an ICP (inductively coupled plasma) etching apparatus, a TCP (transfer coupled plasma) etching apparatus, and so on.

For example, an RIE apparatus that applies power to top and bottom electrodes was used for etching, instead of using the magnetron RIE apparatus (DRM). In this example, a C₄F₈/N₂/Ar-based mixed gas was used at the flow ratio of 5/150/1000 sccm (the total flow rate: 1155 sccm, the Ar flow ratio: 87%). The RF power to the top electrode was set to 1200 W, the RF frequency was set to 60 MHz, the RF power to the bottom electrode was set to 1700 W, the RF frequency was set to 2 MHz, the pressure was set to 13.3 Pa, the He pressure to the back face of a wafer W was set to 1330 Pa at the center and 4655 Pa at the edge, and the temperatures of the top/sidewall/bottom ESC were set to 50/30/30°C respectively. The interval between the electrodes was 30 mm.

As a result, the etching rate of 410 nm/min for the SiOC film, the selection ratio of 20 for the SiOC film 33 to the silicon nitride film 32, and the micro-trench value of 0 nm were achieved.

A hydrofluorocarbon-based gas may be also used instead of the fluorocarbon-based gas, and for example, a CHF₃ gas, a CH₃F gas, a CH₂F₂ gas, a C₂H₂F₄ gas, a C₂H₆F₂ gas, or the like may be used.

Here, the use of the hydrofluorocarbon-based gas enables the reduction in a facetted portion 35 of the photoresist film 34 in FIG. 2B. For example, in FIG. 2B, a CHF₃/N₂/Ar-based mixed gas was used at the flow ratio of 20/40/1000 sccm, and in the aforesaid RIE apparatus applying the power to top/bottom electrodes, the RF power to the top electrode was set to 1200 W, the RF power to the bottom electrode was set to 1700 W, and the pressure was set to 9.98 Pa. Note that the thickness T1 of the SiOC film 33 was 500 nm. As a result, the remaining thickness T2 of the photoresist film 34 was 470 nm and the remaining thickness T3 of the photoresist film 34 on the facetted portion side was 240 nm.

Meanwhile, when a C₄F₆/CHF₃/N₂/Ar-based mixed gas was used at the flow ratio of 5/20/300/200 sccm, the remaining thickness T2 of the photoresist film 34 was 450 nm and the remaining thickness T3 of the photoresist film 34 on the facetted portion side was 130 nm. These results show that the use of the CHF₃/N₂/Ar-based mixed gas makes it possible to increase the remaining thickness T3 of the photoresist film 34 on the facetted portion side.

FIG. 7A to FIG. 7F are cross sectional views showing a dual damascene process according to an embodiment of the present invention. In FIG. 7A, after a silicon nitride film 42 is formed on a Cu wiring layer 41 by CVD, coating, or the like, a low dielectric constant insulating film 43 is formed on the silicon nitride film 42. Then, a photoresist film 44 is formed on the low dielectric constant insulating film 43, and an opening portion H3 matching a via hole B2 is formed in the photoresist film 44 through the use of a photolithography technique.

Next, as shown in FIG. 7B, etching E3 using a C₄F₈/N₂/Ar- based mixed gas in which the flow ratio of an Ar gas is 80% or higher is conducted, with this photoresist film 44 serving as a mask, thereby forming the via hole B2 in the low dielectric constant insulating film 43. Here, the use of the C₄F₈/N₂/Ar-based mixed gas in which the flow ratio of the Ar gas is 80% or higher makes it possible to improve the selection ratio of the low dielectric constant insulating film 43 to the silicon nitride film 42 to 10 or higher, so that etching of the low dielectric constant insulating film 43 using the silicon nitride film 42 as an etch stop layer can be conducted with high precision.

Next, as shown in FIG. 7C, the photoresist film 44 is removed and a photoresist film 45 is formed over the entire surface. Then, an opening portion H4 matching a trench T2 is formed in the photoresist film 45 through the use of the photolithography technique.

Next, as shown in FIG. 7D, with this photoresist film 45 being used as a mask, etching E4 was conducted for the low dielectric constant insulating film 43 halfway to the bottom thereof, using the C₄F₈/N₂/Ar-based mixed gas in which the flow ratio of the Ar gas is 80% or higher, thereby forming the trench T2 in the low dielectric constant insulating film 43. Incidentally, when the etching is conducted halfway to the bottom of the low dielectric constant insulating film 43, the end point of the etching can be estimated based on the time obtained by the reverse calculation from the etching rate. Here, the use of the C₄F₈/N₂/Ar-based mixed gas in which the flow ratio of the Ar gas is 80% or higher makes it possible to make a micro-trench smaller, so that a conductive material 46 can be uniformly buried in the trench T2.

Next, as shown in FIG. 7E, the photoresist film 45 is removed, and etching E5 is conducted using the low dielectric constant insulating film 43 as a mask, thereby forming an opening portion NH in the silicon nitride film 42.

Next, as shown in FIG. 7F, the conductive material 46 such as Cu is deposited over the entire surface. Then, the surface of this conductive material 46 is planarized using CMP (chemical mechanical polishing), thereby forming a via in the via hole B and also forming wiring in the trench T2.

As is explained above, according to the present invention, the selection ratio of the organic insulating film to the silicon nitride film can be enhanced and the micro-trenches generated at the time of etching the organic insulating film can be made smaller.

### Industrial Applicability

A method for etching an organic insulating film and a dual damascene process according to the present invention are usable in the semiconductor manufacturing industry in which semiconductor devices are manufactured, and so on. Therefore, both have industrial applicability.

## Claims

1. A method for etching an organic insulating film, wherein an etching gas is a mixed gas containing a fluorocarbon-based gas, an N₂ gas, and an inert gas whose flow ratio to a total flow rate of the etching gas is 80% or higher.

2. A method for etching an organic insulating film as set forth in claim 1, wherein the organic insulating film is an SiOC-based low dielectric constant film.

3. A method for etching an organic insulating film as set forth in claim 1, wherein a selection ratio of the organic insulating film to a silicon nitride film (etching rate of the organic insulating film/etching rate of the silicon nitride film) is about 10 or higher.

4. A method for etching an organic insulating film as set forth in claim 1, wherein a micro-trench value by the etching gas is 40 nm or less.

5. A method for etching an organic insulating film as set forth in claim 1, wherein the inert gas is an Ar gas.

6. A method for etching an organic insulating film as set forth in claim 5, wherein the fluorocarbon-based gas is a C₄F₈ gas.

7. A method for etching an organic insulating film as set forth in claim 5, wherein the fluorocarbon-based gas is a C₄F₆ gas.

8. A method for etching an organic insulating film, comprising:
etching an organic insulating film with a resist film serving as a mask layer, by using an etching gas containing a hydrofluorocarbon-based gas, an N₂ gas, and an inert gas whose flow ratio to a total flow rate of the etching gas is 80% or higher.

9. A method for etching an organic insulating film as set forth in claim 8, wherein the inert gas is an Ar gas.

10. A method for etching an organic insulating film as set forth in claim 9, wherein the hydrofluorocarbon-based gas is a CHF₃ gas.

11. A dual damascene process comprising:
forming a via hole in an organic insulating film with a nitride film serving as an etch stop layer, by using an etching gas containing a fluorocarbon-based gas, an N₂ gas, and an inert gas whose flow ratio to a total flow rate of the etching gas is 80% or higher;
etching the organic insulating film halfway to a bottom by using the etching gas, to thereby form a trench in the organic insulating film; and
burying a conductive material in the via hole and the trench.

12. A dual damascene process as set forth in claim 11, wherein the inert gas is an Ar gas.

13. A dual damascene process as set forth in claim 12, wherein the fluorocarbon-based gas is a C₄F₈ gas.

14. A dual damascene process as set forth in claim 12, wherein the fluorocarbon-based gas is a C₄F₆ gas.
